# EUROPÄISCHE PATENTSCHRIFT

(11) **EP 1 901 897 B1**
(45) Veröffentlichungstag und Bekanntmachung des Hinweises auf die Patenterteilung: **04.11.2009**
(21) Anmeldenummer: 06753899.1
(22) Anmeldetag: 26.05.2006
(51) Int. Cl.: B28D 5/00, B23D 57/00, H01L 21/67

(54) **EINRICHTUNG ZUM POSITIONIEREN UND LAGEERHALTEN VON DÜNNEN SUBSTRATEN AM GESCHNITTENEN SUBSTRATBLOCK**
DEVICE FOR POSITIONING AND BLOCKING THIN SUBSTRATES ON A CUT SUBSTRATE BLOCK
DISPOSITIF DE POSITIONNEMENT ET DE FIXATION DE SUBSTRATS FINS SUR UN BLOC DE SUBSTRATS DECOUPE

(30) Priorität: 13.06.2005 DE 102005028112
(43) Veröffentlichungstag der Anmeldung: 26.03.2008
(60) Teilanmeldung: 09011321.8
(73) Patentinhaber: Schmid Technology Systems GmbH, 78078 Niedereschach (DE)
(72) Erfinder: GENTISCHER, Josef, 71384 Weinstadt (DE); HABERMANN, Dirk, 79199 Kirchzaarten (DE)
(74) Vertreter: Patentanwälte Ruff, Wilhelm, Beier, Dauster & Partner
(86) Internationale Anmeldenummer: PCT/EP2006/005037
(87) Internationale Veröffentlichungsnummer: WO 2006/133798

(56) Entgegenhaltungen:
- EP-A- 0 762 483
- DE-A1- 19 950 068
- US-A1- 2004 159 316

## Beschreibung

Die vorliegende Erfindung bezieht sich auf eine Einrichtung zum Positionieren und Lageerhalten von dünnen Substraten, vorzugsweise Siliziumwafern nach dem Schneiden, vorzugsweise Drahtsägen des Substratblocks, vorzugsweise Siliziumwaferblocks, nach dem Oberbegriff des Anspruchs 1.

Insbesondere für fotovoltaische Zellen werden sehr dünne, weniger als 0,3 mm starke Wafer aus Siliziumblöcken mit Drahtsägen herausgeschnitten. Dazu wird der Waferblock zunächst mit einer Trägerglasplatte verklebt, die wiederum mit einer Maschinenträgerleiste verbunden ist. Eine Vielzahl von Sägedrähten durchdringen den Waferblock gleichzeitig und schneiden bis in das Glas der Trägerglasplatte. Dadurch hängen die einzelnen Wafer nur noch an einer der Waferdicke entsprechenden Klebenaht fest. An dieser Stelle bleibt der Sägespalt erhalten. Da es für den weiteren Prozess erforderlich ist, die Wafer ständig feucht zu halten, kleben diese an ihren der Trägerglasplatte abgewandten Bereichen durch die Flüssigkeit büschelweise zusammen. Für den weiteren Verarbeitungsprozess ist es erforderlich die Wafer von der Klebenaht abzulösen und zu vereinzeln. Die Massenfertigung erfordert es, diesen Vorgang zu automatisieren. Ziel einer jeden automatisierten Fertigung ist es, eine bestehende Ordnung und Position aufrecht zu erhalten.

Nach einer aus der DE 199 04 834 A1 bekannten Einrichtung ist der geschnittene Waferblock nicht in hängender sondern horizontal liegender Anordnung auf einen Tragarm eines Hubwerks in Flüssigkeit getaucht gehalten. Dabei kippen die einzelnen Wafer aus ihrer horizontalen Lage um die Klebeverbindung mit der Trägerglasplatte an ihrem freien Ende ab, so dass sie dort am darunter liegenden Wafer haften. Werden die Wafer nach und nach von der Trägerglasplatte getrennt, gelangen sie ganzflächig auf den darunterliegenden Wafer, was das Vereinzeln noch schwieriger gestaltet.

Die US 2004/0159316 A1 beschreibt eine Einrichtung zum Zersägen eines Substratblocks mittels Drahtsägen. Eine diesen Substratblock aufnehmende Kassette weist seitlich jeweils eine Andrückleiste auf, die aus elastischem Kunststoff besteht und gegen die Seitenkanten der zerschnittenen Wafer gedrückt wird. Die Leisten weisen eine aufblasbare Innenkammer auf, durch die sie aufgeblasen werden können zum seitlichen Anliegen an den Seitenkanten der Wafer. Durch Einstellen des Innendrucks kann eine Anlage kraftreguliert werden.

Aufgabe der vorliegenden Erfindung ist es deshalb, eine Einrichtung und ein Verfahren zum Positionieren und Lageerhalten von dünnen Substraten, vorzugsweise Siliziumwafern der eingangs genannten Art zu schaffen, bei der bzw. bei dem die Wafer in ihrer Lage und Position auch nach dem Ablösen der Trägerglasplatte fixiert sind und insbesondere der Spalt im Bereich der Verbindungsstelle mit der dann abgelösten Trägerglasplatte erhalten bleibt und so die nachfolgende Vereinzelung vereinfacht.

Zur Lösung dieser Aufgabe sind bei einer Einrichtung der eingangs genannten Art die im Anspruch 1 angegebenen Merkmale vorgesehen.

Durch die erfindungsgemässen Massnahmen ist erreicht, dass der Abstand zwischen den einzelnen Wafern nach dem Schneiden des Waferblocks und die Position der einzelnen Wafer zumindest im Bereich der Verbindungsstelle mit der Trägerglasplatte auch nach deren Ablösen erhalten bleibt und so eine Vereinzelung bzw. einzelnes Abnehmen der Wafer vom geschnittenen Waferblock in einfacher und schneller Weise möglich ist.

Mit den Merkmalen nach Anspruch 2 ist erreicht, dass die Wafer zunächst zu beiden Seitenkanten des Waferblocks im Bereich nahe der Verbindungsstelle auf Abstand gehalten werden können, auch wenn die einzelnen Wafer an ihren der Trägerglasplatte abgewandten unteren Kanten aneinander gelangen.

In vorteilhafter Weise sind die Merkmale nach Anspruch 3 vorgesehen, so dass in einfacher Weise eine Fixierung der Spalte zwischen den Wafern möglich ist.

Mit den Merkmalen nach Anspruch 4 ist eine einfache Höhenfixierung des Waferblocks innerhalb der Kassette erreicht.

Um das fixierte Einsetzen des Waferblocks in die Kassette zu erreichen, sind die Merkmale nach Anspruch 5 vorgesehen.

Gemäß einer bevorzugten Ausführungsform sind die Merkmale nach Anspruch 6 vorgesehen. Auf diese Weise ist es möglich nach dem Ablösen der Trägerglasplatte die einzelnen Wafer im Bereich der oberen Stirnkante zusätzlich auf Abstand zu halten. Dabei kann es zweckmäßig sein, zusätzlich zu den oberen Andrückleisten auch obere zusätzliche Führungsholme für die weitere Bearbeitung bzw. Handhabung des geschnittenen Waferblocks innerhalb der Kassette zu erleichtern.

Es ist zweckmäßig, die Merkmale nach Anspruch 8 vorzusehen, um mit dem Ablösen und Abnehmen bzw. Entfernen der Trägerglasplatte gleichzeitig die oberen Andrückleisten und oberen Führungsholme an den geschnittenen Waferblock heranzubringen. Sollen die Wafer in einer seitlichen Richtung oder nach Drehung um 90° in vertikaler Richtung aus der Kassette heraus vereinzelt und entfernt werden, sind die Merkmale nach Anspruch 9 vorgesehen, was bedeutet, dass die Kassette, nachdem sie von der Oberseite her geschlossen worden ist, nunmehr an einer der seitenränder geöffnet worden ist. Wegen möglicher Riefen in den Waferoberflächen durch das Drahtsägen wird auf diese Weise das Vereinzeln und Entfernen der Wafer aus der Kassette vereinfacht.

Die Merkmale nach einem der Ansprüche 11 und/oder 12 ermöglichen ein Vereinzeln und Entfernen der Wafer aus der Kassette, entweder in vertikaler oder horizontaler Richtung, je nach dem, ob die Oberseite der Kassette oder eine der Längsseiten der umgedrehten oder gedrehten Kassette geöffnet bleibt bzw. wird.

Die vereinzelten Wafer können nach dem Abnehmen der Trägerglasplatte bspw. in zum Einsetzen des geschnittenen Waferblocks entgegengesetzter Richtung einzeln herausgenommen werden.

Beim bevorzugt angewendeten Verfahren werden in vorteilhafter Weise, die Wafer in einer Richtung vereinzelt und vom geschnitten Waferblock entfernt, die mit dem Verlauf der sich beim Schneiden bzw. Drahtsägen des Waferblocks ergebenden Riefen in den Oberflächen der einzelnen Wafer übereinstimmt, was ein reibungs- und verzahnungsfreies Bewegen beim Vereinzeln und Entfernen der einzelnen Wafer gewährleistet. Dies kann entweder in seitlicher, das heißt horizontaler Richtung, oder nach einer 90°-Drehung in vertikaler Richtung erfolgen, so dass der für das Einsetzen des Waferblocks vorgegebene Bezugspunkt verbleibt.

Weitere Einzelheiten der Erfindung sind der folgenden Beschreibung zu entnehmen, in der die Erfindung anhand der in der Zeichnung dargestellten Ausführungsbeispiele näher und erläutert ist. Es zeigen:
- Figur 1: in schematischer Vorderansicht einen geschnitten Waferblock, wie er in einer fixierenden Kassette aufgenommen und noch mit einer Trägerglasplatte verbunden ist,
- Figur 2: einen Schnitt längs der Linie II-II der Figur 1,
- Figuren 3 bis 6: verschiedene Ausführungsformen der distanzwahrenden und haltgebenden Andrückleisten in vergrößerter Darstellung,
- Figur 7: in Vorderansicht den von der Trägerglasplatte befreiten Waferblock in der Kassette stehend mit einer über den einzelnen Wafern angeordneten Sprüheinrichtung sowie einer Vakuumpinzette zum Vereinzeln am geschnittenen Waferblock und Entfernen der Wafer aus der Kassette gemäß einem ersten Ausführungsbeispiel vorliegender Erfindung und
- Figur 8: eine der Darstellung der Figur 2 entsprechende Schnittdarstellung, jedoch gemäß einem zweiten Ausführungsbeispiel vorliegender Erfindung.

Die in Zeichnung gemäß zweier Ausführungsbeispiele dargestellte Einrichtung 10 bzw. 10' dient zum Positionieren und Lageerhalten von dünnen Substraten, vorzugsweise von dünnen Siliziumwafern 14, nach dem Schneiden, vorzugsweise Drahtsägen, eines Substratblocks, vorzugsweise Siliziumwaferblocks 13 . Der Waferblock 13 ist zusammen mit einer noch verklebt angebrachten Trägerglasplatte 11, die an einer Maschinenträgerplatte 12 befestigt ist, mittels Drahtsägen gleichmäßig in dünne maximal 0,3 mm dicke Wafer 14 bis zur Oberfläche der Trägerglasplatte 11 geschnitten. Die Einrichtung 10 bzw. 10' dient dabei dazu, die Wafer 14 vom Waferblock 13 in einfacher und schneller weise zu vereinzeln und einer weiteren Bearbeitung zuzuführen.

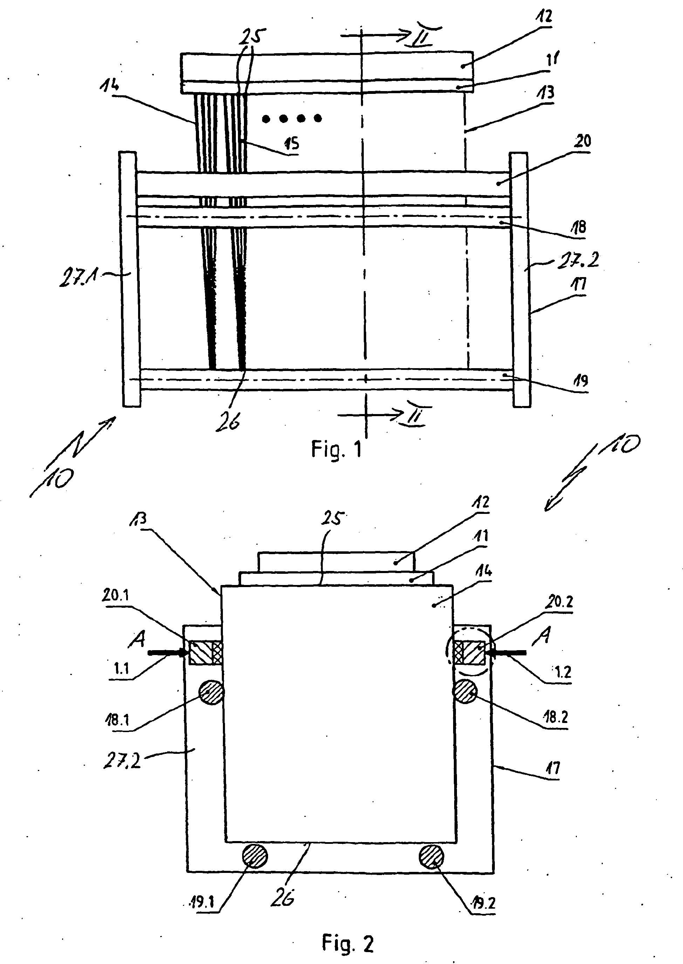

Die Wafer 14 des geschnittenen Waferblocks 13 werden an der Trägerglasplatte 11 hängend in eine Kassette 17 eingebracht. Dabei sind die Wafer 14 an ihren Verbindungsklebestellen 25 noch im Abstand des sich ergebenden Sägespaltes 15 angeordnet, während sie im Bereich ihrer den Verbindungsklebestellen 25 abgewandten Unterkanten 26 mit ihren benachbarten wafern 14 büschelweise zusammenhängen (Figur 1).

Die Kassette 17 besitzt eine von ihrer Oberseite her offene im Querschnitt U-förmige Konstruktion, bei der an beiden Enden je ein U-förmiges Rahmenteil 27.1 und 27.2 vorgesehen ist, das parallel zu den Wafern 14 bzw. deren Sägespalte 15 angeordnet ist. Der Abstand der beiden Rahmenteile 27.1 und 27.2 ist etwas größer als die Abmessung des Waferblocks 13 bzw. der Trägerglasplatte 11. Die beiden Rahmenteile 27.1 und 27.2 sind einerseits durch als Rundstäbe ausgeführte seitliche Führungsholme 18.1 und 18.2 und andererseits durch ebenfalls als Rundstäbe ausgeführte bodenseitige Stützholme 19.1 und 19.2 auf Abstand gehalten. Der Abstand der im oberen Bereich der Rahmenteile 27.1 angeordneten einander gegenüberliegenden Führungsholme 18.1 und 18.2 entspricht der Breite der Wafer 14 bzw. des Waferblocks 13, so dass der geschnittene Waferblock 13 von der Oberseite der Kassette 17 her passend und geführt in den Innenraum der Kassette eingebracht werden kann. Die bodenseitigen Stützholme 19.1 und 19.2 dienen als Auflage der Unterkanten 26 der Wafer 14, besitzen also einen entsprechenden horizontalen Abstand voneinander. Der Waferblock 13 befindet sich über eine wesentliche Länge innerhalb der Kassette 17.

In einem oberen Bereich der beiden Rahmenteile 27.1 und 27.2 und oberhalb der beiden Führungsholme 18.1 und 18.2 sind einander gegenüber liegende Andrückleisten 20.1 und 20.2 in horizontaler Richtung bewegbar gehalten. Die in Richtung der Pfeile A gegeneinander bewegbar gehaltenen Andrückleisten 20.1 und 20.2 dienen zur Positionierung und Lageerhaltung der an der Trägerglasplatte 11 hängend gehaltenen Wafer 14 und damit dazu, den Sägespalt 15 zwischen den Wafern 14 in einem Bereich unterhalb der Verbindungsklebestellen 25 zu fixieren bzw. aufrecht zu erhalten. Sobald der geschnittene Waferblock 13 an der Trägerglasplatte 11 hängend gehalten in die Kassette 17 eingesetzt ist, werden die Andrückleisten 20.1 und 20.2 in Richtung des Pfeiles A auf die Seitenkanten 28 der Wafer 14 zubewegt, so dass die Wafer 14 in der in Figur 1 dargestellten Weise in diesem Bereich auf Abstand gehalten werden.

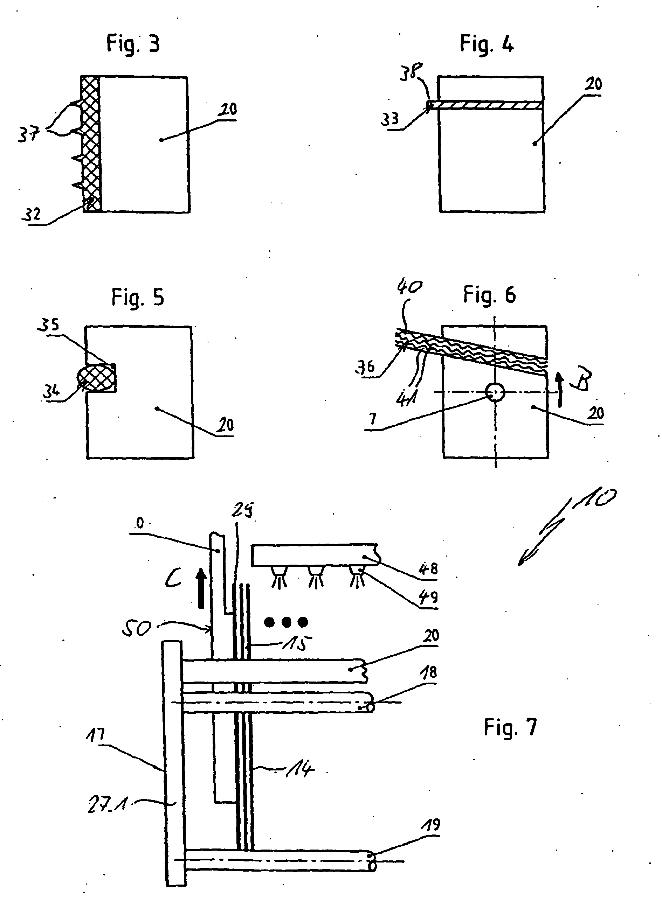

Die Andrückleisten 20.1 und 20.2. können in unterschiedlicher Weise ausgebildet sein, wie dies in den Figuren 3 bis 6 dargestellt ist. Jede Andrückleiste 20 besitzt dem Waferblock 13 bzw. den Wafern 14 zugewandte Aufsätze 32, 33, 34 bzw. 36, die in der Lage sind, sich in den in diesem Bereich noch vorhandenen dünnen Sägespalt 15 einzudrücken bzw. einzuschieben und damit die Wafer 14 an dieser Stelle auf Distanz zu halten und ihnen einen seitlichen Halt zu geben, wenn in einem darauffolgenden Schritt die Trägerglasplatte 11 mit der Maschinenträgerleiste 12 nach Auf- bzw. Ablösen des Klebers an den Verbindungsklebestellen 25 abgenommen bzw. entfernt wird.

Gemäss Figur 3 besitzt der elastische Aufsatz 32 horizontal nach vorne stehende und im Abstand angeordnete dreieckförmige bzw. keilförmige Stege 37. Gemäss Figur 4, die nicht zur beanspruchten Erfindung gehört, besitzt der Aufsatz 33 als distanzwahrendes und haltgebendes Element eine elastische Lamelle 38. Gemäss Figur 5, die nicht zur beanspruchten Erfindung gehört, ist der Aufsatz 34 in

Form eines plastischen Wulstes 39 ausgebildet, der in einer Nut der Andrückleiste 20 eingebracht ist und über deren Vorderkante vorsteht. Beim Andrücken sowohl der Lamelle 38 als auch des Wulstes 39 an die Seitenkanten 28 der Wafer 14 verformt sich die Lamelle 38 bzw. der Wulst 39 derart, dass sie bzw. er bereichsweise zwischen die Wafer 14 bzw. in deren Sägespalte 15 gedrückt wird. Nach Figur 6, die nicht zur beanspruchten Erfindung gehört, besitzt der Aufsatz 36 eine Bürstenleiste 40, die durch Schwenken der Andrückleiste 20 in Richtung des Pfeiles B derart an die Seitenkanten 28 der Wafer 14 herangebracht wird, dass bereichsweise Borsten 41 in die Sägespalte 15 gelangen.

Sobald die Andrückleisten 20.1 und 20.2, von denen auch mehrere übereinander angeordnet sein können, in Position gebracht sind, wird, wie erwähnt, die Trägerglasplatte 11 von den Wafern 14 insgesamt abgelöst, wie dies aus Figur 7 ersichtlich ist. Danach wird eine mit einer Vielzahl von Düsenelementen 49 versehene Sprüheinrichtung 48 oberhalb der Oberkante 29 der Wafer 14 in Position gebracht. Mit Hilfe dieser Sprüheinrichtung 48 werden die Wafer 14 mit einer Flüssigkeit berieselt, die in die Sägespalte 15 im Bereich der Oberkanten der Wafer 14 gelangt und dadurch die Wafer 14 längs ihrer Unterkante, über die die Wafer 14 büschelweise einander hängen, geöffnet werden, so dass auch dort wieder ein kleiner Spalt entsteht.

Einem der Rahmenteile 27.1 und 27.2 benachbart ist eine Vakuumpinzette 50 angeordnet, mit der grossflächig die einzelnen Wafer 14 erfasst vereinzelt und vom geschnittenen Block abgenommen werden können. Beim Ausführungsbeispiel der Figur 7 erfolgt dies in Richtung des Pfeiles C, d.h. über die offene obere Seite der Kassette 17 hinweg.

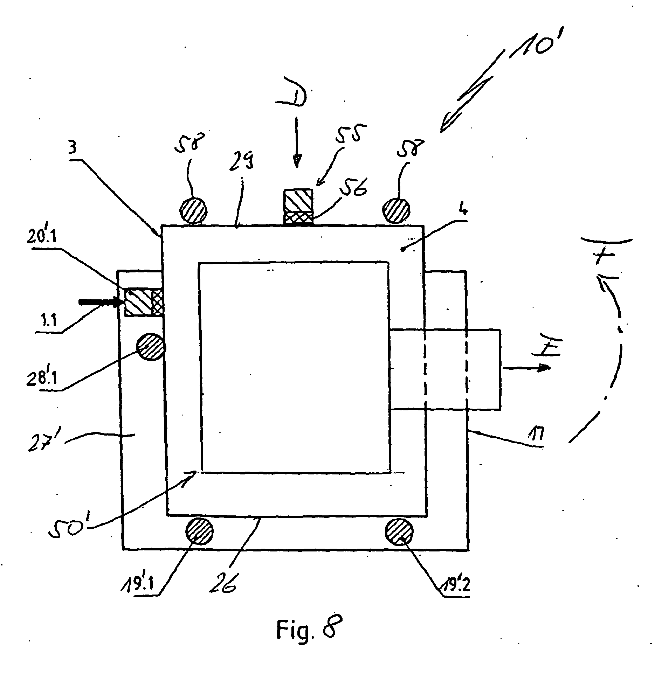

Figur 8 zeigt eine zweite bevorzugte Ausführungsform vorliegender Erfindung, bei welcher Einrichtung 10' die Kassette 17 ' die im wesentlichen in gleicher Weise ausgebildet ist, d.h., mit Rahmenteilen 27'.1 und 27'.2, mit Führungsholmen 18'.1 und 18'.2 und Stützholmen 19'.1 und 19'.2 sowie mit im oberen Bereich der Kassette 17 und oberhalb der Führungsholme 18' angeordneten Andrückleisten 20'.1 und 20'.2 versehen ist.

Auch bei diesem Ausführungsbeispiel werden entsprechend Figur 1 die durch das Schneiden (Drahtsägen) des Waferblocks 13 gebildeten Wafer 14 über Verbindungsklebestellen 25 an der Trägerglasplatte 11 hängend über die oben offene Seite der Kassette 17' in diese bis zur Auflage auf den Stützholmen 19'.1 und 19'.2 eingesetzt. Sobald die Andrückleisten 20'.1 und 20'.2 in ihren bezüglich der Wafer 14 distanzwahrende und haltgebende Positionen eingefahren sind und sobald die Trägerglasplatte 11 zusammen mit den Maschinenträgerleisten 12 von den Oberkanten 29 der Wafer 14 abgenommen und aus dem Bereich der Kassette 17' entfernt ist, werden eine oder mehr nebeneinander angeordnete obere Andrückleisten 55 über die Oberkanten 29 der Wafer 14 gebracht und in vertikaler Richtung gemäß Pfeil D auf diese derart aufgelegt, dass die Oberkanten 29 der Wafer 14 in ihrer Position und Lage gehalten werden. Diese eine oder mehrere obere Andrückleisten 55 können eine in den Andrückleisten 20' entsprechende Ausgestaltung aufweisen; sie sind jedenfalls derart ausgebildet, dass sie distanzwahrende und haltgebende Aufsätze 56 besitzen, die die Sägespalte 15 in diesem oberen Bereich aufrecht erhalten.

Zusätzlich zu diesen oberen Andrückleisten 55 können benachbart ein oder mehrere zusätzliche obere Führungsholme 58' angeordnet sein. Zwischen den oberen Andrückleisten 55 und den oberen Führungsholmen 58 kann in nicht dargestellter Weise eine Sprüheinrichtung 48 mit Düsen 49 angeordnet sein, die eine Flüssigkeit in die Sägespalte 15 zum Öffnen bzw. Auseinanderbringen der aneinanderhaftenden Wafer 14 im Bereich ihrer Unterkante 26 dienen.

Zum Vereinzeln sowie Abnehmen und Herausnehmen der Wafer 14 aus der Kassette 17' wird die Kassette 17' an einem der beiden Seitenbereiche geöffnet. Hierzu sind beispielsweise der Führungsholm 18'.2 sowie die Andrückleiste 20'.2 aus dem Seitenbereich der Kassette 17' entfernbar bzw. bewegbar derart, dass diese Seite der Kassette 17' geöffnet wird. Eine Vakuumpinzette 50' erfasst die einzelnen Wafer 14 großflächig. Gemäß Figur 8 kann die Vakuumpinzette 50' jeden einzelnen Wafer 14 in Richtung des Pfeiles E in horizontaler Richtung aus der nunmehr offenen Seite der Kassette 17' heraus bewegen.

In nicht dargestellter Weise ist es jedoch zweckmäßiger, wenn die Einrichtung 10' bzw. die Kassette 17' gemäß dem strichpunktierten Pfeil F um 90º gedreht wird, so dass die Wafer 14 durch die Vakuumpinzette 50' entsprechend dem Ausführungsbeispiel der Figur 7 in vertikaler Richtung 6 aus der Kassette 17' herausbewegt werden, so dass die Bezugsebene bzw. der Bezugspunkt entsprechend dem Einsetzen des geschnittenen Waferblocks 13 verbleibt.

Die Bewegung der einzelnen Wafer 14 relativ zueinander erfolgt in beiden Fällen anders als beim Ausführungsbeispiel gemäß Figur 7 in einer Richtung parallel zu durch das Drahtsägen an den Oberflächen der Wafer 14 entstandenen Riefen. Nach dem Ausführungsbeispiel der Figur 7 erfolgt das Bewegen der Wafer 14 mit Hilfe der Vakuumpinzette 50 quer zur Richtung möglicher Riefen in den Waferoberflächen, was ein aneinander Reiben und damit Behindern des Vereinzelns mit sich bringt. Das Herausbewegen der Wafer 14 mit Hilfe der Vakuumpinzette 50' aus der Kassette 17' ist durch die einander gegenüberliegenden Stützholme 19'.1, 19'.2 und dem mindestens einen oberen Führungsholm 58' geführt und erleichtert.

Es versteht sich, dass das Drehen der Einrichtung 10' bzw. der Kassette 17' auch vor dem seitlichen Öffnen erfolgen kann, das heißt, dass der Führungsholm 18'.2 und die Andrückleiste 20'.2 erst nach der 90º-Drehung zum Öffnen der Kassette 17'-entfernt werden.

## Patentansprüche

1. Einrichtung (10) zum Positionieren und Lageerhalten von dünnen Substraten, vorzugsweise Siliziumwafern (14), nach dem Schneiden, vorzugsweise Drahtsägen eines Substratblocks, vorzugsweise Siliziumwaferblocks (13), wobei eine den Waferblock (13) aufnehmende Kassette (17) mit zwei oder mehr Andrückleisten (20) versehen ist, deren dem Waferblock (13) zugewandte Seiten mit Elementen (32) versehen sind, die in den engen Schneidspalt (15) zwischen den Wafern (14) distanzwahrend und haltgebend eingreifen, **dadurch gekennzeichnet, dass** das distanzwahrende und haltgebende Element (32) als elastisches Profil mit spitzen dreieckförmigen Stegen (37) ausgebildet ist.

2. Einrichtung nach Anspruch 1, **dadurch gekennzeichnet, dass** sich gegenüberliegende seitliche Andrückleisten (20) mit ihren distanzwahrenden und haltgebenden Elementen (32) im oberen Bereich der Kassette (17) in Bereiche der Schneidspalte (15) zwischen den Seitenkanten (28) der Wafer (14) des an einer Trägerglasplatte (11) hängend in die Kassette (17) eingetauchten und dem Kassettenboden zugewandten geschnittenen Waferblocks (13) greifen.

3. Einrichtung nach Anspruch 2, **dadurch gekennzeichnet, dass** die seitlichen Andrückleisten (20) mit ihren distanzwahrenden und haltgebenden Elementen (32) in die Schneidspalte (15) horizontal einfahrbar oder einschwenkbar sind.

4. Einrichtung nach mindestens einem der vorhergehenden Ansprüche, **dadurch gekennzeichnet, dass** die Kassette (17) bodenseitig mit Stützholmen (19) für die der Trägerglasplatte (11) abgewandten Waferstirnkanten (26) versehen ist.

5. Einrichtung nach mindestens einem der vorhergehenden Ansprüche, **dadurch gekennzeichnet, dass** die Kassette (17) mit seitlichen Führungsholmen (18) für die Waferseitenkanten (28) versehen ist.

6. Einrichtung nach mindestens einem der vorhergehenden Ansprüche, **dadurch gekennzeichnet, dass** eine oder mehr nebeneinander liegende obere Andrückleisten (20') mit ihren distanzwahrenden und haltgebenden Elementen dem Kassettenboden abgewandt anordenbar sind und in Bereiche der Schneidspalte (15) zwischen den Oberkanten (29) der Wafer (14) des von der Trägerglasplatte (11) befreiten geschnittenen Waferblocks (13) greifen.

7. Einrichtung nach Anspruch 6, **dadurch gekennzeichnet, dass** die Oberkante (29) der Wafer (14) des von der Trägerglasplatte (11) befreiten Waferblocks (13) von einem oder mehreren oberen Führungsholmen (58) abdeckbar sind.

8. Einrichtung nach den Ansprüchen 6 und 7, **dadurch gekennzeichnet, dass** die obere Andrückleiste (20') und der obere Führungsholm (18') nach Entfernen der Trägerglasplatte (11) zu den Oberkanten der Wafer (14) des Waferblocks (13) hin bewegbar sind.

9. Einrichtung nach mindestens einem der Ansprüche 2 bis 8, **dadurch gekennzeichnet, dass** einer der beiden seitlichen Führungsholme (18) sowie eine der beiden einander gegenüberliegenden seitlichen Andrückleisten (20) mit ihren distanzwahrenden und haltgebenden Elementen zum seitlichen Öffnen der Kassette (17) entfernbar sind.

10. Einrichtung nach mindestens einem der vorhergehenden Ansprüche, **dadurch gekennzeichnet, dass** eine flächige Sprühvorrichtung (48) über den Oberkanten der Wafer (14) des von der Trägerglasplatte (11) befreiten Waferblocks (13) angeordnet ist.

11. Einrichtung nach mindestens einem der vorhergehenden Ansprüche, **dadurch gekennzeichnet, dass** eine Vakuumpinzette (50) an einer Seite des geschnittenen Waferblock (13) innerhalb der Kassette (17) vorgesehen ist.

12. Einrichtung nach Anspruch 11, **dadurch gekennzeichnet, dass** die Vakuumpinzette (50) in vertikaler oder horizontaler Richtung zur Entnahme eines Wafers (14) aus der Kassette (17) bewegbar ist.

## Claims

1. A device (10) for positioning and blocking thin substrates, preferably silicon wafers (14), after the cutting, preferably wire sawing of a substrate block, preferably a silicon wafer block (13), wherein a cassette (17) that receives the wafer block (13) is provided with two or more contact strips (20), whose sides, facing the wafer block (13), are provided with elements (32), which engage in the narrow cutting gap (15) between the wafers (14) in a distancing and supporting manner, wherein the distancing and supporting element (32) is designed as an elastic profile having pointed, triangular attachments (37).

2. The device as recited in Claim 1, wherein lateral contact strips (20), which are situated opposite each other, with their distancing and supporting elements (32) in the upper area of the cassette (17), engage in areas of the cutting gaps (15) between the side edges (28) of the wafers (14) of the cut wafer block (13) that is inserted into the cassette (17) while hanging from a supporting glass plate (11) and that faces the base of the cassette.

3. The device as recited in Claim 2, wherein the lateral contact strips (20) having their distancing and supporting elements (32) can be horizontally engaged in, or pivoted into, the cutting gaps (15).

4. The device as recited in at least one of the preceding claims, wherein the cassette (17) on its base side is provided with protective bars (19) for the wafer end edges (26) that face away from the supporting glass plate (11).

5. The device as recited in at least one of the preceding claims, wherein the cassette (17) is provided with lateral guide bars (18) for the wafer side edges (28).

6. The device as recited in at least one of the preceding claims, wherein one or more upper contact strips (20'), situated next to each other, can be arranged with their distancing and supporting elements facing away from the base of the cassette and engage in areas of the cutting gaps (15) between the upper edges (29) of the wafers (14) of the cut wafer block (13) that is detached from the supporting glass plate (11).

7. The device as recited in Claim 6, wherein the upper edge (29) of the wafers (14) of the wafer block (13) that is detached from the supporting glass plate (11) can be covered by one or more upper guide bars (58).

8. The device as recited in Claim 6 and 7, wherein the upper contact strip (20') and the upper guide bar (18') can be moved towards the upper edges of the wafers (14) of the wafer block (13) after the removal of the supporting glass plate.

9. The device as recited in at least one of Claims 2 to 8, wherein one of the two lateral guide bars (18) and one of the two side contact strips (20) facing each other with their distancing and supporting elements can be removed for opening the side of the cassette (17).

10. The device as recited in at least one of the preceding claims, wherein a large-surface spray device (48) is arranged above the upper edges of the wafers (14) of the wafer block (13) that has been detached from the supporting glass plate (11).

11. The device as recited in at least one of the preceding claims, wherein a vacuum tweezer (50) is provided on one side of the cut wafer block (13) within the cassette (17).

12. The device as recited in Claim 11, wherein the vacuum tweezer (50) can be moved in the vertical or horizontal direction to remove a wafer (14) from the cassette (17).

## Revendications

1. Système (10) de positionnement et d'immobilisation de minces substrats, de préférence des galettes (14) de silicium, après la coupe et de préférence le sciage au fil d'une pile de substrats, de préférence une pile (13) de galettes de silicium,
dans lequel une cassette (17) qui loge la pile (13) de galettes est dotée de deux ou plusieurs lattes de poussée (20) dont le côté tourné vers la pile (13) de galettes est doté d'éléments (32) qui s'engagent dans les étroits interstices de coupe (15) entre les galettes (14) en maintenant l'écartement et à titre de soutien,
**caractérisé en ce que**
l'élément (32) de maintien de l'écartement et de soutien est configuré comme profilé élastique à nervures triangulaires pointues (37).

2. Système selon la revendication 1, **caractérisé en ce que** les lattes de poussée (20) opposées latéralement dans la partie supérieure de la cassette (17) s'engagent par leurs éléments (32) de maintien de l'écartement et de soutien dans la zone des interstices de coupe (15) situés entre les chants latéraux (28) de la galette (14) de la pile (13) de galettes découpées suspendues à une plaque de support (11) en verre, enfoncées dans la cassette (17) et tournées vers la base de la cassette.

3. Système selon la revendication 2, **caractérisé en ce que** les éléments (32) de maintien de l'écartement et de soutien des lattes latérales de poussée (20) peuvent être insérés horizontalement ou inclinés dans les interstices de coupe (15).

4. Système selon au moins l'une des revendications précédentes, **caractérisé en ce que** du côté de la base, la cassette (17) est dotée d'une barre se soutien (19) pour les chants frontaux (26) des galettes non tournés vers la plaque de support (11) en verre.

5. Système selon au moins l'une des revendications précédentes, **caractérisé en ce que** la cassette (17) est dotée de barres latérales de guidage (18) pour les chants latéraux (28) des galettes.

6. Système selon au moins l'une des revendications précédentes, **caractérisé en ce qu'**une ou plusieurs lattes supérieures de poussée (20') situées les unes à côtés des autres peuvent être disposées avec leurs éléments de maintien de l'écartement et de soutien sur le côté non tourné vers la base de la cassette et s'engagent dans les parties des interstices de coupe (15) situées entre les chants supérieurs (29) des galettes (14) de la pile (13) de galettes découpées et détachées de la plaque de support (11) en verre.

7. Système selon la revendication 6, **caractérisé en ce que** les chants supérieurs (29) des galettes (14) de la pile (13) de galettes découpées détachées de la plaque de support (11) en verre peuvent être recouverts par une ou plusieurs barres de guidage (58).

8. Système selon les revendications 6 et 7, **caractérisé en ce que** la latte supérieure de poussée (20') et la barre supérieure de guidage (18') peuvent être déplacées vers le chant supérieur des galettes (14) de la pile (13) de galettes après que la plaque de support (11) en verre a été enlevée.

9. Système selon au moins l'une des revendications 2 à 8, **caractérisé en ce qu'**une des deux barres latérales de guidage (18) ainsi que l'une des deux lattes de poussée (20) peuvent être enlevées avec leurs éléments (32) de maintien de l'écartement et de soutien pour ouvrir la cassette (17) par le côté.

10. Système selon au moins l'une des revendications précédentes, **caractérisé en ce qu'**un dispositif plat de pulvérisation (48) est disposé au-dessus des chants supérieurs des galettes (14) de la pile (13) de galettes découpées et détachées de la plaque de support (11) en verre.

11. Système selon au moins l'une des revendications précédentes, **caractérisé en ce qu'**une pincette aspirante (50) est prévue à l'intérieur de la cassette (17) sur un côté de la pile (13) de galettes découpées.

12. Système selon la revendication 11, **caractérisé en ce que** la pincette aspirante (50) peut être déplacée dans la direction verticale et dans la direction horizontale pour retirer une galette (14) de la cassette (17).
